# EUROPEAN PATENT APPLICATION

(11) **EP 4 611 518 A1**
(43) Date of publication of application: **03.09.2025**
(21) Application number: 24194468.5
(22) Date of filing: 14.08.2024
(51) Int. Cl.: H10K 59/80, H10K 59/122, H10K 59/124

(54) **DISPLAY DEVICE**

(30) Priority: 28.02.2024 KR 20240028737
(71) Applicant: LG Display Co., Ltd., Seoul 07336 (KR)
(72) Inventor: JUNG, Seyeon, 10845 Paju-si, Gyeonggi-do (KR); KIM, JeongOh, 10845 Paju-si, Gyeonggi-do (KR); YOO, MyungJae, 10845 Paju-si, Gyeonggi-do (KR); LEE, Geumyoung, 10845 Paju-si, Gyeonggi-do (KR); YU, Jaechoul, 10845 Paju-si, Gyeonggi-do (KR)
(74) Representative: Viering, Jentschura & Partner mbB Patent- und Rechtsanwälte

(57) **Abstract**

A display device (100, 200, 300, 400) includes a first substrate (110) having a display area (AA) and a non-display area (NA), a planarization layer (130, 330) disposed in the display area (AA) and the non-display area (NA) on the first substrate (110), a light emitting diode (OLED) disposed in the display area (AA) on the planarization layer (130, 330) and including an anode (AN), an organic layer, and a cathode (CA), a protection layer (140, 240) disposed in the display area (AA) and the non-display area (NA) on the planarization layer (130, 330), and disposed to cover an end of the anode (AN) and to surround a side surface of the planarization layer (130, 330), a bank (150, 250, 350, 450) disposed on at least a portion of the protection layer (140, 240) to cover the end of the anode (AN), a second substrate (170) disposed to face the first substrate (110), and an adhesive layer (160, 260, 360, 460) disposed on the bank (150, 250, 350, 450) to adhere the second substrate (170) and the first substrate (110). Thus, moisture permeation into organic layer at an outer peripheral area may be reduced.

## Description

### CROSS-REFERENCE TO RELATED APPLICATIONS

This application claims the priority of Korean Patent Application No. 10-2024-0028737 filed on February 28, 2024, in the Korean Intellectual Property Office.

### BACKGROUND

### Field

The present disclosure relates to a display device, and more particularly, a display device with improved moisture permeability characteristics.

### Description of the Related Art

With the development of the information age, the demand for display devices that display images is increasing. The display devices may be used in various types of devices such as TVs, monitors, tablet computers, navigators, game consoles, and mobile phones. Various types of display devices are used as such a display device, examples of which include a liquid crystal display (LCD) device, an organic light emitting display (OLED) device, and the like.

The range of applications of display devices is more diversified, including not only computer monitors and TVs but also personal portable devices, and researches are being conducted on display devices that have a large display area but reduced volume and weight.

### SUMMARY

An object to be achieved by the present disclosure is to provide a display device in which a moisture permeation path at an outer peripheral area is blocked.

Another object to be achieved by the present disclosure is to provide a display device that is capable of reducing the occurrence of defects in light emitting diodes due to moisture permeation.

Still another object to be achieved by the present disclosure is to provide a display device that is capable of easily absorbing outgassing of a planarization layer.

Objects of the present disclosure are not limited to the above-mentioned obj ects, and other objects, which are not mentioned above, can be clearly understood by those skilled in the art from the following descriptions. According to an aspect of the present disclosure, a display device according to claim 1 is provided. Further embodiments are described in the dependent claims.

According to an aspect of the present disclosure, a display device comprises a first substrate having a display area and a non-display area, a planarization layer disposed in the display area and the non-display area on the first substrate, a light emitting diode disposed in the display area on the planarization layer and including an anode, an organic layer, and a cathode, a protection layer disposed in the display area and the non-display area on the planarization layer, and disposed to cover an end of the anode and to surround a side surface of the planarization layer, a bank disposed on at least a portion of the protection layer to cover the end of the anode, a second substrate disposed to face the first substrate, and an adhesive layer disposed on the bank to adhere the second substrate and the first substrate.

According to an embodiment of the present disclosure, a display device includes a substrate, a thin film transistor on the substrate, an insulating layer on the thin film transistor, a light emitting diode on the planarization layer. The light emitting diode may include a first electrode, an organic emitting layer, and a second electrode. The display device further includes a protection layer on the insulating layer. One or more openings may be formed in the protection layer to expose one or more portions of the insulating layer. The display device further includes a bank disposed on and contacting at least a portion of the protection layer, an adhesive layer on the bank, and a second substrate on the adhesive layer.

Other detailed matters of the exemplary embodiments are included in the detailed description and the drawings.

According to the present disclosure, a protection layer may be disposed to surround a planarization layer to block a path of moisture permeation that may occur at an outer peripheral area.

The present disclosure may reduce or minimize degradation of reliability due to a defect of a light emitting diode caused by moisture permeation.

According to the present disclosure, a plurality of openings may be disposed in a protection layer made of an inorganic material to provide a path through which outgassing inside a planarization layer is absorbed.

The effects according to the present disclosure are not limited to the contents exemplified above, and more various effects are included in the present specification.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a plan view schematically illustrating a display device according to an exemplary embodiment of the present disclosure.
FIG. 2 is a cross-sectional view taken along the line II-II' of FIG. 1.
FIG. 3 is a cross-sectional view taken along the line III-III' of FIG. 1.
FIG. 4 is a cross-sectional view illustrating a display device according to another exemplary embodiment of the present disclosure.
FIG. 5 is a cross-sectional view illustrating a display device according to still another exemplary embodiment of the present disclosure.
FIG. 6 is a cross-sectional view illustrating a display device according to still another exemplary embodiment of the present disclosure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, exemplary embodiments of the present disclosure will be described in detail with reference to accompanying drawings.

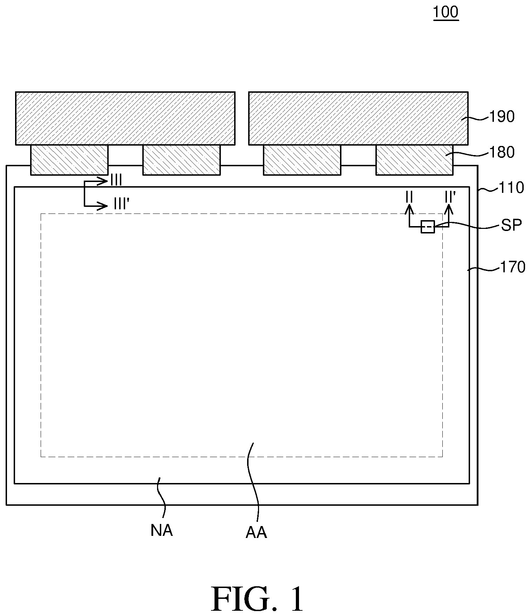

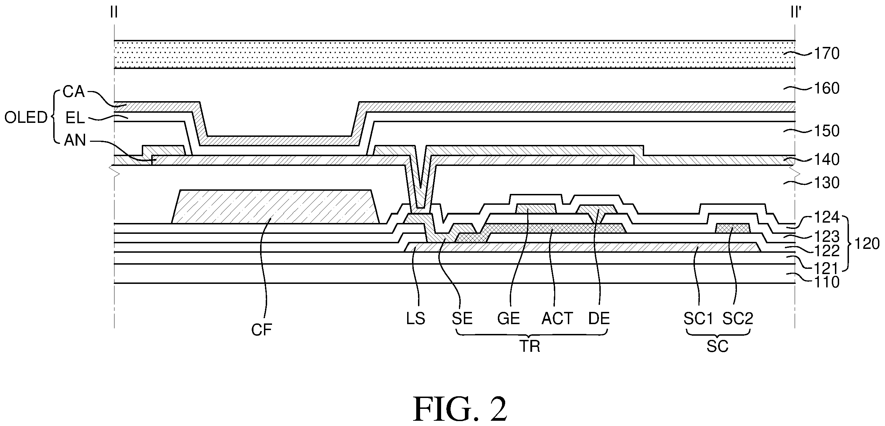

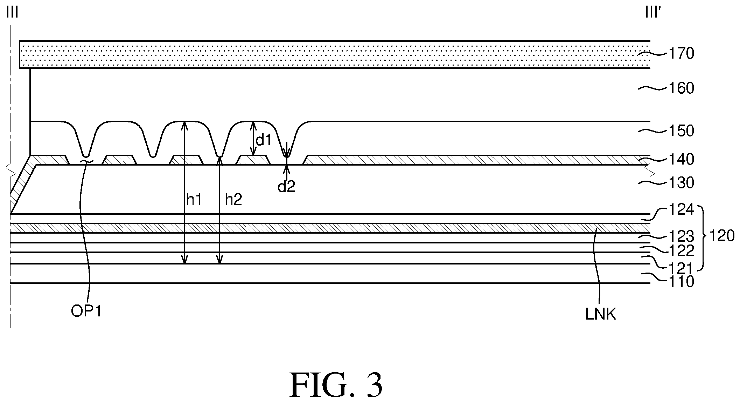

FIG. 1 is a plan view schematically illustrating a display device according to an exemplary embodiment of the present disclosure. FIG. 2 is a cross-sectional view taken along the line II-II' of FIG. 1. FIG. 3 is a cross-sectional view taken along the line III-III' of FIG. 1. For convenience of explanation, FIG. 1 merely illustrates a first substrate 110, a second substrate 170, a plurality of flexible films 180, and a plurality of printed circuit boards 190 among various components of a display device 100. Meanwhile, in FIGS. 2 and 3, the plurality of flexible films 180 and the plurality of printed circuit boards 190 are omitted for convenience of explanation.

Referring to FIGS. 1 to 3, the first substrate 110 may be configured to support various components included in the display device 100. The first substrate 110 may be made of an insulating material or a material with flexibility. For example, the substrate 110 may be a plastic substrate, such as polymer or polyimide (PI).

Meanwhile, the display device 100 may be configured as a top emission or bottom emission type depending on a direction in which light emitted from a light emitting diode OLED is emitted.

The top emission type is configured such that light is emitted from a light emitting diode toward the top of the first substrate 110 on which the light emitting device OLED is disposed. As for the top emission type, a reflective layer may be formed below an anode AN to make light emitted from the light emitting diode OLED proceed to the top of the first substrate 110, namely, toward a cathode CA.

The bottom emission type is configured such that light is emitted from a light emitting diode toward the bottom of the first substrate 110 on which the light emitting device OLED is disposed. As for the bottom emission type, in order to make light emitted from the light emitting diode OLED proceed to the bottom of the first substrate 110, an anode AN may be made only of a transparent conductive material and a cathode CA may be made of a metal material with high reflectivity.

Hereinafter, for convenience of explanation, it is assumed that the display device 100 according to an exemplary embodiment of the present disclosure is a bottom emission type, but the present disclosure is not limited thereto.

Referring to FIG. 1, the first substrate 110 includes a display area AA and a non-display area NA.

The display area AA is an area where images are displayed. A plurality of sub-pixels SP for displaying images may be disposed in the display area AA. The plurality of sub-pixels SP includes a red sub-pixel, a green sub-pixel, a blue sub-pixel, and a white sub-pixel. For example, the red sub-pixel, the white sub-pixel, the blue sub-pixel, and the green sub-pixel may be sequentially disposed along a row direction. However, the disposition order of the plurality of sub-pixels SP is not limited thereto.

Each of the plurality of sub-pixels SP includes an emission area and a circuit area. The emission area is an area where light of a single color may be independently emitted, and a light emitting diode OLED may be disposed in the emission area. Specifically, an area, which is exposed from a bank 150, among areas where a plurality of color filters CF and anodes AN overlap each other, to allow light emitted from the light emitting diode OLED to proceed outside, may be defined as the emission area. The circuit area is the remaining area excluding the emission area, and may include a driving circuit for driving a plurality of light emitting diodes OLED and a plurality of lines for transmitting various signals to the driving circuit. Additionally, the circuit area where the driving circuit, the plurality of lines, the bank 150, and the like are disposed may be a non-emission area.

A non-display area NA is an area where an image is not displayed and is disposed to surround the display area AA. The non-display area NAmay be an area where various lines, driving integrated circuits (ICs), etc. for driving the plurality of sub-pixels SP disposed in the display area AA are disposed. For example, various driving ICs, such as gate driving ICs and data driving ICs, may be disposed in the non-display area NA, but are not limited thereto. The non-display area NA in which an image is not displayed may be a bezel area, but the exemplary embodiments of the present disclosure are not limited thereto.

Referring to FIG. 2 for describing the configuration of the sub-pixels SP, each sub-pixel SP includes a first substrate 110, an inorganic insulating layer 120, a planarization layer 130, a protection layer 140, a bank 150, an adhesive layer 160, a first transistor TR, a storage capacitor SC, a light emitting diode OLED, and a color filter CF.

The inorganic insulating layer 120 is disposed on the first substrate 110. The inorganic insulating layer 120 may include an insulating layer 121, a buffer layer 122, a gate insulating layer 123, and a passivation layer 124.

First, the insulating layer 121 is disposed on the first substrate 110. The insulating layer 121 may suppress spreading of moisture and/or oxygen, which permeate from the outside of the first substrate 110. The moisture permeation property of the display device 100 may be controlled by controlling the thickness or stacking structure of the insulating layer 121. Additionally, the insulating layer 121 may suppress a short defect, which occurs due to a contact between the first substrate 110, which is made of a transparent conductive oxide or oxide semiconductor, and other components such as a transistor. The insulating layer 121 may be made of an inorganic material, for example, may be configured by a single layer of silicon oxide (SiOx) or silicon nitride (SiNx) or a multi-layer thereof, but is not limited thereto.

A light shielding layer LS is disposed on the insulating layer 121. The light shielding layer LS may be made of a conductive material. For example, the light shielding layer LS may be made of a conductive material, such as copper (Cu), aluminum (Al), molybdenum (Mo), nickel (Ni), titanium (Ti), chromium (Cr), or an alloy thereof, but is not limited thereto. The light shielding layer LS may be disposed to overlap an active layer ACT of the transistor TR to shield light incident on the active layer ACT. When light is irradiated to the active layer ACT, a leakage current may be generated. This may decrease the reliability of the transistor TR, which is a driving transistor. At this time, when the light shielding layer LS, which is made of an opaque conductive material, such as copper (Cu), aluminum (Al), molybdenum (Mo), nickel (Ni), titanium (Ti), chromium (Cr), or an alloy thereof, is disposed to overlap the active layer ACT, light incident on the active layer ACT from the bottom of the first substrate 110 may be blocked, thereby improving the reliability of the transistor TR.

Meanwhile, in the drawing, the light shielding layer LS is shown as a single layer, but the light shielding layer LS may also include a plurality of layers. For example, the light shielding layer LS may include a plurality of layers disposed to overlap each other with interposing at least one of the insulating layer 121, the buffer layer 122, the gate insulating layer 123, and a passivation layer 124 therebetween.

The buffer layer 122 is disposed on the light shielding layer LS. The buffer layer 122 may reduce permeation of moisture or impurities through the first substrate 110. For example, the buffer layer 122 may be formed by a single layer or a multi-layer of silicon oxide (SiOx) or silicon nitride (SiNx), but is not limited thereto. Additionally, the buffer layer 122 may be omitted depending on the type of the first substrate 110 or the type of a transistor, but is not limited thereto.

The transistor TR and the storage capacitor SC are disposed on the buffer layer 122 in each of the plurality of sub-pixels SP.

First, the transistor TR includes an active layer ACT, a gate electrode GE, a source electrode SE, and a drain electrode DE.

The active layer ACT is disposed on the buffer layer 122. The active layer ACT may be made of a semiconductor material such as oxide semiconductor, amorphous silicon, or polysilicon, but is not limited thereto. For example, when the active layer ACT is formed of an oxide semiconductor, the active layer ACT may include a channel region, a source region, and a drain region, and the source region and drain region may be conductive regions, but are limited to this.

The gate insulating layer 123 is disposed on the active layer ACT. The gate insulating layer 123 is a layer for insulating a gate electrode GE from the active layer ACT and may be made of an insulating material. For example, the gate insulating layer 123 may be formed by a single layer or a multi-layer of silicon oxide (SiOx) or silicon nitride (SiNx), but is not limited thereto.

The gate electrode GE is disposed on the gate insulating layer 123 to overlap the active layer ACT. The gate electrode GE may be made of a conductive material, for example, copper (Cu), aluminum (Al), molybdenum (Mo), nickel (Ni), titanium (Ti), chromium (Cr), or an alloy thereof, but is not limited thereto.

A source electrode SE and a drain electrode DE are disposed on the gate insulating layer 123 to be spaced apart from each other. The source electrode SE and the drain electrode DE may be electrically connected to the active layer ACT through a contact hole, which is formed in the gate insulating layer 123. The source electrode SE and the drain electrode DE may be disposed on the same layer as the gate electrode GE and thus may be made of the same conductive material, but are not limited thereto. For example, the source electrode SE and the drain electrode DE may be made of copper (Cu), aluminum (Al), molybdenum (Mo), nickel (Ni), titanium (Ti), chromium (Cr), or an alloy thereof, but are not limited thereto.

Meanwhile, although not illustrated in FIG. 2, the drain electrode DE may be electrically connected to a high potential power line to be supplied with a high potential power voltage. At this time, in order to electrically connect the drain electrode DE to the high potential power line, an auxiliary high potential power line may be further disposed. One end of the auxiliary high potential power line may be electrically connected to the high potential power line and the other end may be electrically connected to the drain electrode of each of the plurality of sub-pixels SP. For example, when the auxiliary high potential power line is made of the same material as the drain electrode DE on the same layer, one end of the auxiliary high potential power line may be electrically connected to the high potential power line through contact holes, which are formed in the gate insulating layer 123 and the buffer layer 122. The other end of the auxiliary high potential power line may extend toward a drain electrode DE to be integrally formed with the drain electrode DE. However, the drain electrode DE and the high potential power line may be electrically connected in different manners, and are not limited thereto.

The source electrode SE may be electrically connected to the light shielding layer LS through the contact holes formed in the gate insulating layer 123 and the buffer layer 122. Additionally, a portion of the active layer ACT connected to the source electrode SE may be electrically connected to the light shielding layer LS through the contact hole formed in the buffer layer 122. If the light shielding layer LS is floated, the threshold voltage, and the like of the transistor TR may change, affecting the driving of the display device 100. Accordingly, a voltage may be applied to the light shielding layer LS by electrically connecting the light shielding layer LS to the source electrode SE, thereby suppressing the affection to the driving of the transistor TR. However, in the present disclosure, it has been described that both the active layer ACT and the source electrode SE are in contact with the light shielding layer LS, but alternatively, only one of the source electrode SE and the active layer ACT may be directly in contact with the light shielding layer LS, but is not limited thereto.

Meanwhile, in FIG. 2, the gate insulating layer 123 is shown as being formed on the entire surface of the first substrate 110, but the gate insulating layer 123 may be patterned to overlap only the gate electrode GE, the source electrode SE, and the drain electrode DE, but is not limited thereto.

The storage capacitor SC is disposed in the circuit area of each of the plurality of sub-pixels SP. The storage capacitor SC may store a voltage between the gate electrode GE and the source electrode SE of the transistor TR so that the light emitting diode OLED maintains the same state for one frame. The storage capacitor SC includes a first capacitor electrode SC1 and a second capacitor electrode SC2.

The first capacitor electrode SC1 is disposed between the insulating layer 121 and the buffer layer 122 in each of the plurality of sub-pixels SP. The first capacitor electrode SC 1 may be disposed closest to the first substrate 110 among conductive components disposed on the first substrate 110. The first capacitor electrode SC1 may be integrally formed with the light shielding layer LS and may be electrically connected to the source electrode SE through the light shielding layer LS.

The buffer layer 122 is disposed on the first capacitor electrode SC1 and the second capacitor electrode SC2 is disposed on the buffer layer 122. The second capacitor electrode SC2 may be disposed to overlap the first capacitor electrode SC1. The second capacitor electrode SC2 may be electrically connected to the gate electrode GE. For example, a semiconductor material may be disposed on the buffer layer 122 and a portion of the semiconductor material may be converted into a conductor to form the second capacitor electrode SC2, but is not limited thereto.

In summary, the first capacitor electrode SC1 of the storage capacitor SC may be integrally formed with the light shielding layer LS and may be electrically connected to the light shielding layer LS and the source electrode SE. The second capacitor electrode SC2 may be electrically connected to the gate electrode GE. Accordingly, the first capacitor electrode SC1 and the second capacitor electrode SC2 that overlap each other with the buffer layer 122 interposed therebetween may constantly maintain the voltage of the gate electrode GE and the source electrode SE of the transistor TR while the light emitting diode OLED emits light, thereby maintaining the light emitting diode OLED in the same state.

A passivation layer 124 is disposed on the storage capacitor SC. The passivation layer 124 is an insulating layer to protect the configuration below the passivation layer 124. For example, the passivation layer 124 may be formed by a single layer or a multi-layer of silicon oxide (SiOx) or silicon nitride (SiNx), but is not limited thereto. Additionally, the passivation layer 124 may be omitted depending on an exemplary embodiment.

A color filter CF is disposed on the passivation layer 124 in the emission area of each of the plurality of sub-pixels SP. As described above, the display device 100 according to an exemplary embodiment of the present disclosure is the bottom emission type in which light emitted from the light emitting diode OLED is directed to the bottom of the light emitting diode OLED and the first substrate 110. Thus, the color filter CF may be disposed below the light emitting diode OLED. Light emitted from the light emitting diode OLED may be implemented as light of various colors through the color filter CF.

The planarization layer 130 is disposed in the display area AA and the non-display area NA on the passivation layer 124 and the color filter CF. The planarization layer 130 is an insulating layer that planarizes the upper portion of the first substrate 110 on which the transistor TR and the storage capacitor SC are disposed. The planarization layer 130 may be made of an organic material, for example, may be formed by a single layer or multi-layer of polyimide or photo acryl, but is not limited thereto.

The light emitting diode OLED is disposed in the emission area of each of the plurality of sub-pixels SP. The light emitting diode OLED is disposed in the display area AA on the planarization layer 130 in each of the plurality of sub-pixels SP. The light emitting diode OLED includes an anode AN, a light emitting layer EL, and a cathode CA.

The anode AN is disposed on the planarization layer 130 in the emission area EA. Since the anode AN supplies holes to the light emitting layer EL, it may be made of a conductive material with a high work function and may also be referred to as the anode AN. The anode AN, for example, may be formed of a transparent conductive material, such as indium tin oxide ITO, or indium zinc oxide IZO, but is not limited thereto.

On the other hand, the anode AN may extend toward the circuit area CA. A portion of the anode AN may extend from the emission area EA toward the source electrode SE of the circuit area CA, and may be electrically connected to the source electrode SE through contact holes formed in the planarization layer 130 and the passivation layer 124. Accordingly, the anode AN of the light emitting diode OLED may extend to the circuit area to be electrically connected to the source electrode SE of the transistor TR and the first capacitor electrode SC1 of the storage capacitor SC.

The light emitting layer EL is disposed on the anode AN in the emission area EA and the circuit area CA. The light emitting layer EL may be configured by one layer over the plurality of sub-pixels SP. That is, the respective light emitting layers EL of the plurality of sub-pixels SP may be integrally connected. The light emitting layer EL may be configured as a single light emitting layer, or may have a structure in which a plurality of light emitting layers emitting light of different colors is stacked. The light emitting layer EL may further include an organic layer such as a hole injection layer, a hole transport layer, an electron transport layer, an electron injection layer, or the like.

The cathode CA is disposed on the light emitting layer EL in the emission area EA and the circuit area CA. Since the cathode CA supplies electrons to the light emitting layer EL, it may be made of a conductive material with a low work function. The cathode CA may be configured by one layer over the plurality of sub-pixels SP. That is, the respective cathodes CA of the plurality of sub-pixels SP may be integrally connected. For example, the cathode CAmay be formed of a transparent conductive material, such as indium tin oxide ITO or indium zinc oxide IZO, or a ytterbium (Yb) alloy, and may further include a metal doping layer, but is not limited thereto. Meanwhile, although not illustrated in FIG. 2, the cathode CA of the light emitting diode OLED may be electrically connected to a low potential power line to be supplied with a low potential power voltage.

The protection layer 140 and the bank 150 are disposed between the anode AN and the light emitting layer EL.

The protection layer 140 is disposed in the display area AA and the non-display area NA on the planarization layer 130. The protection layer 140 is disposed to cover the end of the anode AN in the display area AA. The end of the protection layer 140 is covered with the bank 150, and the protection layer is thus insulated with being spaced apart from the light emitting layer.

The protection layer 140 may be made of an inorganic material. For example, the protection layer 140 may be made of an inorganic material, such as silicon oxide (SiOx), silicon nitride (SiNx), silicon oxynitride (SiNxOy), or aluminum oxide (AlyOz), but is not limited thereto.

The bank 150 is disposed to overlap the display area AA and to cover the end of the anode AN and the end of the protection layer 140 on at least a portion of the protection layer 140. The bank 150 is disposed at a boundary between adjacent sub-pixels SP to reduce color mixing of light emitted from the light emitting diodes OLED of each of the plurality of sub-pixels SP. The bank 150 may be made of an insulating material, for example, may be made of polyimide, acryl, or benzocyclobutene (BCB)-based resin, but is not limited thereto.

The adhesive layer 160 is disposed on the cathode CA. The adhesive layer 160 may adhere the first substrate 110 and the second substrate 170. The adhesive layer 160 may be made of resin, for example, any one of epoxy, phenol, amino, unsaturated polyester, polyimide, silicone, acryl, vinyl, and olefin. The adhesive layer 160 may be adhered by a high-energy curing method, for example, by using heat, ultraviolet rays, or a laser, or may be adhered in a manner of applying physical pressure by using a pressure sensitive adhesive PSA. The adhesive layer 160 may also be configured by a plurality of layers. For example, the adhesive layer 160 may include a layer containing epoxy and polyolefin and a moisture absorption filter layer. At this time, the moisture absorption filter layer may be made of a moisture adsorbent. The adhesive layer 160 may be disposed to be larger than the size of the display area AA and to cover the entire display area AA, so as to obtain an encapsulation effect by covering all of the light emitting diodes OLED within the display area AA.

The second substrate 170 is disposed on the adhesive layer 160. The second substrate 170 may be a thin metal substrate (face seal metal (FSM)) which is made of an opaque material. More specifically, the second substrate 170 may be disposed to completely cover the display area AA to protect the plurality of sub-pixels SP disposed on the first substrate 110 from external impacts and scratches. The metal forming the second substrate 170 may be, for example, a material having a high modulus of about 200 to 900 MPa, and may be aluminum (Al), nickel (Ni), chromium (Cr), or an alloy material of iron (Fe) and nickel, which has high corrosion resistance, and is easily machined into a thin film form.

Referring back to FIG. 1, the second substrate 170 may have a smaller size than the first substrate 110. More specifically, the second substrate 170 is configured such that a flexible film 180, which is electrically connected to one end of the first substrate 110, is exposed to the outside. At this time, the end of the second substrate 170 and the end of the flexible film 180 may be spaced apart by a certain distance.

A film member may be disposed below the first substrate 110. The film member may include at least one of a polarizer and a barrier film. For example, a polarizer is disposed below the first substrate 110. The polarizer may selectively transmit light to reduce the reflection of external light incident on the first substrate 110. Specifically, in the display device 100, various metal materials applied to semiconductor devices, wiring lines, light emitting diodes, etc. are disposed on the first substrate 110. Accordingly, external light incident on the first substrate 110 may be reflected from the metal material, and the visibility of the display device 100 may be reduced due to the reflection of external light. At this time, the outdoor visibility of the display device 100 may be increased by disposing the polarizer, which suppresses the reflection of the external light, below the first substrate 110. This polarizer may be adhered to the first substrate 110 by using an adhesive. However, the polarizer may be omitted depending on the implementation embodiment of the display device 100.

Meanwhile, the barrier film may be disposed below the first substrate 110 together with the polarizer or without the polarizer. The barrier film may reduce or minimize the permeation of moisture and oxygen from outside to inside of the first substrate 110, thereby protecting the light emitting diode OLED. However, the barrier film may be omitted depending on the implementation embodiment of the display device 100, but is not limited thereto.

A plurality of flexible films 180 are disposed on one end of the non-display area NA of the first substrate 110. The plurality of flexible films 180 is films that various components are disposed on a flexible base film to supply signals to the plurality of sub-pixels SP in the display area AA. The plurality of flexible films 180 may be disposed in the non-display area NA of the first substrate 110 to supply data voltages, etc. to the plurality of sub-pixels of the display area AA. Meanwhile, in FIG. 1, there are four flexible films 180, but the number of flexible films 180 may vary depending on the design, and is not limited thereto.

Driving ICs such as gate driver ICs and data driver ICs may be disposed on the plurality of flexible films 180. The driving IC is a component that processes data for displaying images and driving signals for processing the data. Depending on a mounting method, the driving IC may be disposed in a manner of, for example, chip on glass (COG), chip on film (COF), tape carrier package (TCP), etc. In the present disclosure, for convenience of explanation, the driving IC is described as a COF type mounted on the plurality of flexible film 180, but is not limited thereto.

A printed circuit board 190 is connected to the plurality of flexible films 180. The printed circuit board 190 is a component that supplies signals to the driving IC. Various components for supplying various driving signals, such as driving signals, data voltages, etc. to the driving IC may be disposed on the printed circuit board 190. Meanwhile, in FIG. 1, there are two printed circuit boards 190, but the number of printed circuit boards 190 may vary depending on the design, but is not limited thereto.

Referring to FIG. 3, in the display device 100 according to an exemplary embodiment of the present disclosure, the inorganic insulating layer 120, the planarization layer 130, the protection layer 140, the bank 150, and the adhesive layer 160 extend from the display area AA of the first substrate 110 to be disposed in the non-display area NA.

The insulating layer 121, the buffer layer 122, and the gate insulating layer 123, which are included in the inorganic insulating layer 120, may be disposed by extending up to the end of the first substrate 110.

A link line LNK is disposed on the gate insulating layer 123. The link line LNK may transmit signals by being connected to various signal lines or power lines disposed in the display area AA.

The link line LNK may be made of the same material as the gate electrode GE, the source electrode SE, and the drain electrode DE. The link line LNK may be made of a conductive material, for example, copper (Cu), aluminum (Al), molybdenum (Mo), nickel (Ni), titanium (Ti), chromium (Cr), or an alloy thereof, but is not limited thereto.

The passivation layer 124 is disposed on the link line LNK, and the planarization layer 130, the protection layer 140, the bank 150, the adhesive layer 160, and the second substrate 170 are disposed sequentially on the passivation layer 124.

The protection layer 140 may be disposed by extending up to the end of the first substrate 110. The protection layer 140 may be disposed to surround the side surface of the planarization layer 130. Accordingly, the side surface of the planarization layer 130, which is the end of the planarization layer 130, may be covered with the protection layer 140 made of the inorganic material without being exposed to the outside.

A plurality of first openings OP1 exposing the planarization layer 130 are disposed in the protection layer 140. The plurality of first openings OP1 may be disposed in a stripe shape or a mesh shape on a plane. Therefore, in one embodiment, one or more openings are formed in the protection layer 140 to expose one or more portions of the planarization layer 130.

The plurality of first openings OP1 may be formed by etching the protection layer 140 using a bank pattern before the bank 150 is formed as a mask. Specifically, after forming a bank pattern on a portion excluding the plurality of first openings OP1, the protection layer 140 on which the bank pattern is not disposed is etched by using the bank pattern as a mask, thereby forming the plurality of first openings OP1. Thereafter, the bank pattern may reflow along the plurality of first openings OP1 through heat treatment.

As described above, the bank 150 formed by the reflow of the bank pattern may be in contact with the planarization layer 130 through the plurality of first openings OP1. That is, portions, which are disposed in the plurality of first openings OP1, of the lower surface of the bank 150 may be in contact with the upper surface of the planarization layer 130 exposed through the plurality of first openings OP1.

The bank 150 may be disposed to have a curved upper surface along the plurality of first openings OP1. Accordingly, the height h1 of the bank 150 that overlaps the protection layer 140 may be higher than the height h2 of the bank 150 that overlaps the plurality of first openings OP1. That is, the upper surface of the bank 150 disposed on the protection layer 140 may be higher than the upper surface of the bank 150 disposed in the first opening OP1. Here, the height h1, h2 of the bank 150 refers to a height from the substrate 110 to the upper surface of the bank 150. Furthermore, the thickness d1 of the bank 150 that overlaps the protection layer 140 may be greater than the thickness d2 of the bank 150 that overlaps the plurality of first openings OP1. That is, the thickness d1 of the bank 150 disposed on the protection layer 140 may be greater than the thickness d2 of the bank 150 disposed in the first opening OP1. In one embodiment, the thickness of the bank 150 disposed on a portion of the protection layer 140 may be greater than the thickness of the bank 150 disposed on a portion of the planarization layer 130 in a first opening OP1. After forming the bank pattern on the portion excluding the plurality of first openings OP1, the bank pattern may be thermally treated, such that portions of the bank pattern disposed on the protection layer 140 may reflow toward the plurality of first openings OP1. Accordingly, the bank 150 may be disposed to have a curved upper surface along the plurality of first openings OP1.

The adhesive layer 160 is disposed on the bank 150. At this time, the lower surface of the adhesive layer 160 may be in contact with the bank 150. Accordingly, the adhesive layer 160 may absorb outgassing of the planarization layer 130 through the bank 150. At this time, the adhesive layer 160 may be disposed along the curved upper surface of the bank 150 to be in contact with the bank 150 over a wider area.

The bottom emission type display device uses a surface-contact type adhesive layer to delay moisture permeation. At this time, the adhesive layer may delay moisture permeation from the top together with the upper substrate, but it is difficult to block moisture permeating through an organic layer at the outermost peripheral portion, which is the non-display area. This causes a problem in that moisture permeating through the side surface of the organic layer disposed at the outermost peripheral portion reacts with the light emitting diode disposed on the edge of the display area, to thereby arise defects.

Accordingly, in the display device 100 according to an exemplary embodiment of the present disclosure, the protection layer 140 may be disposed between the planarization layer 130 and the bank 150 to suppress moisture permeation through the planarization layer 130 and the bank 150. Specifically, in the display device 100 according to an exemplary embodiment of the present disclosure, the protection layer 140 is disposed in the display area AA and the non-display area NA extending from the display area AA, and located between the planarization layer 130 and the bank 150. Accordingly, the protection layer 140 may suppress moisture permeation through an interface between the planarization layer 130 made of the organic material and the bank 150. Additionally, the protection layer 140 is disposed to surround the side surface of the planarization layer 130 in the non-display area NA. Accordingly, the protection layer 140 may suppress moisture permeation through the side surface of the planarization layer 130 made of the organic material. Therefore, in the display device 100 according to an embodiment of the present disclosure, moisture permeation through the planarization layer 130 made of the organic material and the bank 150 may be reduced or minimized.

Furthermore, in the display device 100 according to an exemplary embodiment of the present disclosure, the moisture permeation through the planarization layer 130 and the bank 150 in the non-display area NA may be reduced or minimized, resulting in reducing or minimizing the defect of the light emitting diode OLED. Specifically, in the display device 100 according to an exemplary embodiment of the present disclosure, the protection layer 140 may be disposed to surround the side surface of the planarization layer 130 and located between the planarization layer 130 and the bank 150 to thus reduce or minimize the moisture permeation. Accordingly, the planarization layer 130 disposed on the upper portion of the light emitting diode OLED may expand in a high temperature and high humidity environment due to moisture permeation, thereby reducing or minimizing the phenomenon that short defects occur between the electrodes electrically connected to the light emitting diode OLED. This may result in improving display quality in the display device 100 according to an exemplary embodiment of the present disclosure.

Meanwhile, outgassing may occur from the planarization layer 130 made of the organic material. The outgassing occurs from the planarization layer 130. If gas is trapped within the planarization layer 130 without being discharged to the outside, a problem that the components disposed on the top of the planarization layer 130 peel off may occur.

Accordingly, in the display device 100 according to an exemplary embodiment of the present disclosure, the plurality of first openings OP1 may be disposed in the protection layer 140 to provide a path through which outgassing from the planarization layer 130 is absorbed. Specifically, as the plurality of first openings OP1 exposing the planarization layer 130 are disposed, portions of the upper surface of the planarization layer 130 may not be covered with the protection layer 140, and the upper surface of the planarization layer 130 corresponding to the plurality of first openings OP1 may be in direct contact with the bank 150. This may result in providing a path through which outgassing within the planarization layer 130 may be absorbed by flowing out toward the adhesive layer 160 through the bank 150. Therefore, in the display device 100 according to an exemplary embodiment of the present disclosure, the plurality of first openings OP1 exposing the planarization layer 130 may be disposed to provide the path through which outgassing of the planarization layer 130 is absorbed. This may improve the peeling effect caused by the outgassing.

In the display device 100 according to an exemplary embodiment of the present disclosure, the plurality of first openings OP1 may be disposed in the protection layer 140, so as to reduce or minimize the peeling phenomenon due to the curved upper surface of the bank 150 disposed along the plurality of first openings OP1. Specifically, in the display device 100 according to an exemplary embodiment of the present disclosure, the curved upper surface of the bank 150 disposed along the plurality of first openings OP1 may be in contact with the lower surface of the adhesive layer 160. Accordingly, compared to the case where the upper surface of the bank 150 is flat, an adhesive area between the bank 150 and the adhesive layer 160 may increase. Therefore, in the display device 100 according to an exemplary embodiment of the present disclosure, the adhesive force of the adhesive layer 160 may be increased by the curved upper surface of the bank 150 disposed along the plurality of first openings OP1.

In the display device 100 according to an exemplary embodiment of the present disclosure, the protection layer 140 may be formed by using the bank pattern, thereby simplifying the process and reducing manufacturing costs. Specifically, in the display device 100 according to an exemplary embodiment of the present disclosure, after forming the bank pattern before the bank 150 is formed, a process of etching the protection layer 140, on which the bank pattern is not disposed, by using the bank pattern as a mask may be performed. Accordingly, a separate process of patterning the protection layer 140 may be eliminated, thereby reducing manufacturing costs. Therefore, in the display device 100 according to an exemplary embodiment of the present disclosure, the protection layer 140 may be formed by using the bank pattern, thereby simplifying the process and reducing the manufacturing costs.

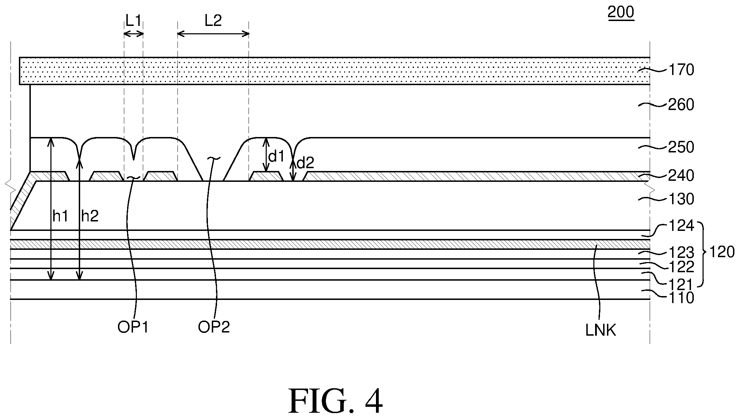

FIG. 4 is a cross-sectional view illustrating a display device according to another exemplary embodiment of the present disclosure. A display device 200 of FIG. 4 is configured to include substantially the same components, except for a protection layer 240, a bank 250, and an adhesive layer 260, compared to the display device 100 of FIGS. 1 to 3. Therefore, redundant description will be omitted.

Referring to FIG. 4, a second opening OP2 may be disposed in the bank 250 to expose the planarization layer 130 in the plurality of first openings OP1. As described above, the plurality of first openings OP1 may be formed by etching the protection layer 240 using the bank pattern before the bank 250 is formed as the mask. At this time, the second opening OP2 may be formed by more widening a spacing between bank patterns. For example, while a spacing between the bank patterns is basically set to a first spacing L1, a spacing between the bank patterns at a specific position may be set to a second spacing L2 wider than the first spacing L1. In this case, the bank patterns disposed at the second spacing, which is the wider gap, may not be connected to each other even if the reflow is performed through heat treatment later. Accordingly, as illustrated in FIG. 4, a portion in which the bank 250 is disconnected may be formed so that the second opening OP2 may be formed in the bank 250.

As the second opening OP2 is disposed in the bank 250, the planarization layer 130 may be exposed through the plurality of first openings OP1 and the second opening OP2. In an area where the first opening OP1 and the second opening OP2 overlap each other, the upper surface of the planarization layer 130 may be exposed without being covered with the protection layer 240 and the bank 250. Accordingly, the planarization layer 130 may be in contact with the adhesive layer 260 in the area where the first opening OP1 and the second opening OP2 overlap each other. That is, a portion of the upper surface of the planarization layer 130 may be in direct contact with a portion of the lower surface of the adhesive layer 260. In one embodiment, a first part of the bank 250 and a second part of the bank 250 are separated from each other, and the adhesive layer 260 contacts a portion of the planarization layer 130 disposed between the first part and the second part of the bank 250.

In the display device 200 according to another exemplary embodiment of the present disclosure, the protection layer 240 may be disposed between the planarization layer 130 and the bank 250 to suppress moisture permeation through the planarization layer 130 and the bank 250. Accordingly, the protection layer 240 may suppress moisture permeation through an interface between the planarization layer 130 made of the organic material and the bank 250. Furthermore, the protection layer 240 may suppress moisture permeation through the side surface of the planarization layer 130 made of the organic material.

In the display device 200 according to another exemplary embodiment of the present disclosure, the moisture permeation through the planarization layer 130 and the bank 250 in the non-display area NA may be reduced or minimized, resulting in minimizing the defect of the light emitting diode OLED and improving the display quality of the display device 200.

In the display device 200 according to another exemplary embodiment of the present disclosure, the protection layer 240 may be formed by using the bank pattern, thereby eliminating a separate process of patterning the protection layer 140 and reducing manufacturing costs.

In the display device 200 according to another exemplary embodiment of the present disclosure, the plurality of first openings OP1 and the second opening OP2 may be disposed to provide a path through which outgassing of the planarization layer 130 is absorbed. Specifically, as the plurality of first openings OP1 and the second opening OP2 exposing the planarization layer 130 are disposed, a portion of the upper surface of the planarization layer 130 may not be covered with the protection layer 240 and the bank 250. That is, the upper surface of the planarization layer 130 corresponding to the plurality of first openings OP1 may be in direct contact with the bank 150, and the upper surface of the planarization layer 130 corresponding to the second opening OP2 may be in direct contact with the adhesive layer 260. This may result in providing a path through which outgassing within the planarization layer 130 may be absorbed through the bank 250 or by directly flowing toward the adhesive layer 260. Therefore, in the display device 200 according to another exemplary embodiment of the present disclosure, the plurality of first openings OP1 and the second opening OP2 exposing the planarization layer 130 may be disposed to provide the path through which outgassing of the planarization layer 130 is absorbed. This may improve the peeling effect caused by the outgassing.

In the display device 200 according to another exemplary embodiment of the present disclosure, the plurality of first openings OP1 and the second opening OP2 may be disposed to reduce or minimize a peeling phenomenon. Specifically, in the display device 200 according to another exemplary embodiment of the present disclosure, the curved upper surface of the bank 250 disposed according to the plurality of first openings OP1 may be in contact with the lower surface of the adhesive layer 260. This may increase an adhesion area between the bank 250 and the adhesive layer 260, compared to the case where the bank 250 has the flat upper surface. Accordingly, the adhesive force of the adhesive layer 260 may increase. In addition, since the planarization layer 130 made of the organic material and the adhesive layer 260 may be in direct contact with each other through the second opening OP2, the adhesive force may further increase. Therefore, in the display device 200 according to another exemplary embodiment of the present disclosure, the adhesive force of the adhesive layer 260 may increase by disposing the plurality of first openings OP1 and the second opening OP2, thereby reducing or minimizing the peeling phenomenon.

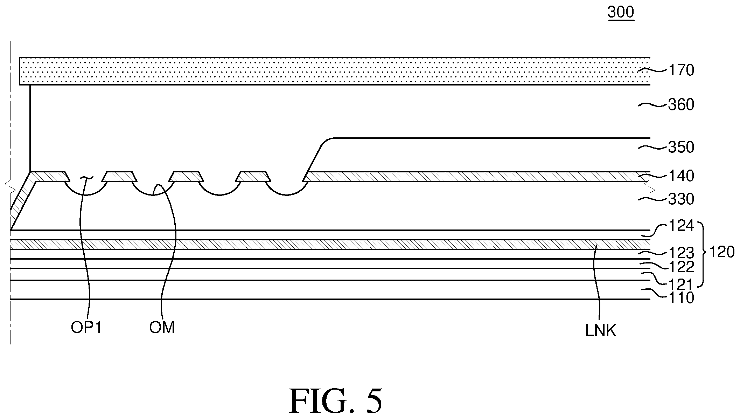

FIG. 5 is a cross-sectional view illustrating a display device according to still another exemplary embodiment of the present disclosure. A display device 300 of FIG. 5 is configured to include substantially the same components, except for a planarization layer 330, a bank 350, and an adhesive layer 360, compared to the display device 100 of FIGS. 1 to 3. Therefore, redundant description will be omitted.

Referring to FIG. 5, the planarization layer 330 may have an upper surface with concave portions OM. The concave portions OM of the upper surface of the planarization layer 330 may be disposed respectively in areas corresponding to the plurality of first openings OP1. Explaining the process of forming the concave portions in the upper surface of the planarization layer 330, bank patterns with different heights are formed on the protection layer 140 in the state where the protection layer 140 is formed on the planarization layer 330. For example, a first bank pattern having a first height is formed on a portion (area) of the non-display area NA, which is adjacent to the display area AA. A second bank pattern having a second height lower than the first height is formed on a portion, in which the plurality of first openings OP1 is not to be disposed, at the outer peripheral area of the first bank pattern. Thereafter, the plurality of first openings OP1 may be formed by etching the protection layer 140 using the bank patterns as masks. Subsequently, an ashing process may be performed. The ashing process may be performed until the bank pattern with the second height is removed. Accordingly, the bank 350 is not disposed on the protection layer 140 while the bank 350 having a height lower than the first height is formed on a portion (area) of the non-display area NA, which is adjacent to the display area AA. In the ashing process, portions of the planarization layer 330 overlapping the plurality of first openings OP1 may be removed, and thus concave portions OM may be formed in the upper surface of the planarization layer 330.

The protection layer 140 disposed between the plurality of first openings OP1 may be in contact with the adhesive layer 360. As described above, in the process of forming the bank 350 using the bank patterns having the different heights, the bank 350 is not formed on the protection layer 140. Therefore, the protection layer 140 disposed between the plurality of first openings OP1 may be in direct contact with the adhesive layer 360. Thus, in one embodiment, the bank 350 is not disposed on another portion of the protection layer 140 in between a first opening OP1 and another first opening OP2 in the protection layer 140.

Additionally, the concave portions OM in the upper surface of the planarization layer 330 may contact the adhesive layer 360. As described above, in the process of removing the bank pattern through the ashing process, the portions of the planarization layer 330 may also be removed, and thus the concave portions OM formed in the upper surface of the planarization layer 330, which overlap the plurality of first openings OP1, may be exposed without being covered with the protection layer 140 and the bank 350. Accordingly, the concave portions in the upper surface of the planarization layer 330 may be in direct contact with the adhesive layer 360.

In the display device 300 according to still another exemplary embodiment of the present disclosure, the protection layer 140 may be disposed between the planarization layer 330 and the bank 350 to suppress moisture permeation through the planarization layer 330 and the bank 350. Accordingly, the protection layer 140 may suppress moisture permeation through an interface between the planarization layer 330 made of the organic material and the bank 350. Furthermore, the protection layer 140 may suppress moisture permeation through the side surface of the planarization layer 330 made of the organic material.

In the display device 300 according to still another exemplary embodiment of the present disclosure, the moisture permeation through the planarization layer 330 and the bank 350 in the non-display area NA may be reduced or minimized, resulting in reducing or minimizing the defect of the light emitting diode OLED and improving the display quality of the display device 300.

In the display device 300 according to still another exemplary embodiment of the present disclosure, the protection layer 140 may be formed by using the bank pattern, thereby eliminating a separate process of patterning the protection layer 140 and reducing manufacturing costs.

In the display device 300 according to still another embodiment of the present disclosure, the plurality of first openings OP1 may be disposed to provide the path through which outgassing of the planarization layer 330 is absorbed. Specifically, by disposing the plurality of first openings OP1 exposing the planarization layer 330, portions of the upper surface of the planarization layer 330 may not be covered with the protection layer 140. That is, the upper surface of the planarization layer 330 corresponding to the plurality of first openings OP1 may be in direct contact with the adhesive layer 360. This may result in providing the path through which the outgassing within the planarization layer 330 may be absorbed by directly flowing toward the adhesive layer 360. Therefore, in the display device 300 according to still another exemplary embodiment of the present disclosure, the plurality of first openings OP1 exposing the planarization layer 330 may be disposed to provide the path through which the outgassing of the planarization layer 330 is absorbed. This may improve the peeling effect caused by the outgassing.

In the display device 300 according to still another exemplary embodiment of the present disclosure, the peeling phenomenon may be reduced or minimized by the concave portions OM in the upper surface of the planarization layer 330 disposed in the portions corresponding to the first openings OP1. Specifically, in the display device 300 according to still another exemplary embodiment of the present disclosure, the concave portions OM of the upper surface of the planarization layer 330 disposed along the plurality of first openings OP1 may be in contact with the lower surface of the adhesive layer 360. This may increase an adhesion area between the planarization layer 330 and the adhesive layer 360, compared to the case where the planarization layer 330 has the flat upper surface. Accordingly, the adhesive force of the adhesive layer 360 may increase. On the other hand, adhesive force between organic materials may be stronger than adhesive force between an inorganic material and an organic material. Accordingly, compared to the adhesion between the protection layer 140 made of the inorganic material and the adhesive layer 360, the adhesive force may be more increased by the direct contact between the planarization layer 330 made of the organic material and the adhesive layer 360. Therefore, in the display device 300 according to still another exemplary embodiment of the present disclosure, the peeling phenomenon may be reduced or minimized as the adhesive force of the adhesive layer 360 is increased by the concave portions OM of the upper surface of the planarization layer 330 disposed in the portions corresponding to the first openings OP1.

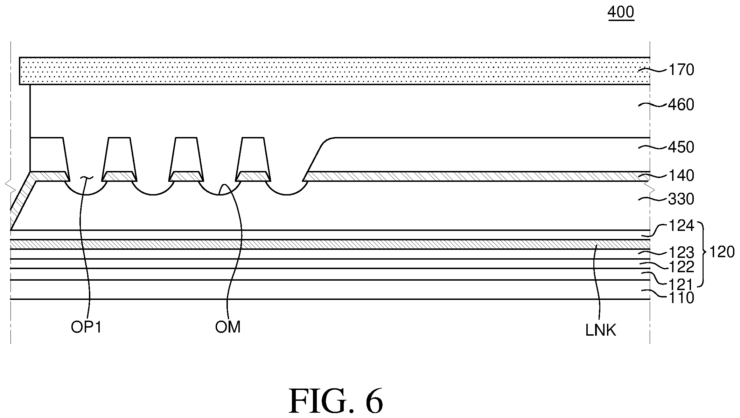

FIG. 6 is a cross-sectional view illustrating a display device according to still another exemplary embodiment of the present disclosure. A display device 400 of FIG. 6 is configured to include substantially the same components, except for a bank 450, compared to the display device 300 of FIG. 5. Therefore, redundant description will be omitted.

Referring to FIG. 6, the bank 450 is disposed to completely overlap the protection layer 140 and may not overlap the plurality of first openings OP1. The plurality of first openings OP1 may be formed by etching the protection layer 140 using the bank 450 as a mask. Specifically, after forming the bank 450 in a portion excluding the plurality of first openings OP1, the protection layer 140 on which the bank 450 is not disposed is etched using the bank 450 as a mask, thereby forming the plurality of first openings OP1. Accordingly, the bank 450 may be disposed only in an area that it overlaps the protection layer 140. Thus, in one embodiment, the bank 450 is disposed on another portion of the protection layer 140 in between a first opening OP1 and another first opening OP2 in the protection layer 140.

The planarization layer 330 may have concave portions in its upper surface. The concave portions OM in the upper surface of the planarization layer 330 may be disposed in areas corresponding to the plurality of first openings OP1. Explaining the process of forming the concave portions OM in the upper surface of the planarization layer 330, the ashing process may be performed in a state in which the protection layer 140 with the plurality of first openings OP1 is formed on the planarization layer 330. Portions of the planarization layer 330 that are not covered with the protection layer 140 may be removed through the ashing process. Accordingly, the concave portions OM may be formed in the upper surface of the planarization layer 330.

The concave portions OM in the upper surface of the planarization layer 330 may contact the adhesive layer 460. As described above, as the portions of the planarization layer 330 are removed through the ashing process, the concave portions OM in the upper surface of the planarization layer 330, which overlap the plurality of first openings OP1, may be exposed without being covered with the protection layer 140 and the bank 450. Accordingly, the concave portions OM in the upper surface of the planarization layer 330 may be in direct contact with the adhesive layer 460.

In the display device 400 according to still another exemplary embodiment of the present disclosure, the protection layer 140 may be disposed between the planarization layer 330 and the bank 450 to suppress moisture permeation through the planarization layer 330 and the bank 450. Accordingly, the protection layer 140 may suppress moisture permeation through an interface between the planarization layer 330 made of the organic material and the bank 450. Furthermore, the protection layer 140 may suppress moisture permeation through the side surface of the planarization layer 330 made of the organic material.

In the display device 400 according to still another exemplary embodiment of the present disclosure, the moisture permeation through the planarization layer 330 and the bank 450 in the non-display area NA may be reduced or minimized, resulting in minimizing the defect of the light emitting diode OLED and improving the display quality of the display device 400.

In the display device 400 according to still another exemplary embodiment of the present disclosure, the protection layer 140 may be formed by using the bank 450, thereby eliminating a separate process of patterning the protection layer 140 and reducing manufacturing costs.

In the display device 400 according to still another exemplary embodiment of the present disclosure, as the plurality of first openings OP1 is disposed, the upper surface of the planarization layer 330 corresponding to the plurality of first openings OP1 may be in direct contact with the adhesive layer 460. This may provide a path through which outgassing inside the planarization layer 330 may be directly absorbed into the adhesive layer 460, resulting in improving the peeling effect due to the outgassing.

In the display device 400 according to still another exemplary embodiment of the present disclosure, the peeling phenomenon may be reduced or minimized by the concave portions OM, which are disposed in the upper surface of the planarization layer 330 disposed in an area corresponding to the plurality of first openings OP1. Specifically, the side and upper surfaces of the bank 450 disposed between the concave portions OM in the upper surface of the planarization layer 330 disposed along the plurality of first openings OP1 and the plurality of first openings OP1 may be in contact with the lower surface of the adhesive layer 460. Accordingly, compared to the case where the upper surface of the planarization layer 330 is flat, the adhesion area between the planarization layer 330 and the adhesive layer 460 may increase, and also the adhesion area may increase by the side and upper surfaces of the bank 450 disposed between the plurality of first openings OP1, thereby increasing the adhesive force of the adhesive layer 460. In addition, the direct contact of the adhesive layer 460 and the planarization layer 330 made of the organic material and the bank 450 may result in a further increase in adhesive force. Therefore, in the display device 400 according to still another exemplary embodiment of the present disclosure, the peeling phenomenon may be minimized as the adhesive force of the adhesive layer 460 is increased by the concave portions OM disposed in the upper surface of the planarization layer 330 disposed in an area corresponding to the first openings OP1 and the side and upper surfaces of the bank 450 disposed between the plurality of first openings OP1.

The exemplary embodiments of the present disclosure can also be described as follows:

According to an aspect of the present disclosure, a display device comprises a first substrate having a display area and a non-display area, a planarization layer disposed in the display area and the non-display area on the first substrate, a light emitting diode disposed in the display area on the planarization layer and including an anode, an organic layer, and a cathode, a protection layer disposed in the display area and the non-display area on the planarization layer, and disposed to cover an end of the anode and to surround a side surface of the planarization layer, a bank disposed on at least a portion of the protection layer to cover the end of the anode, a second substrate disposed to face the first substrate, and an adhesive layer disposed on the bank to adhere the second substrate and the first substrate.

A plurality of first openings may be disposed in the protection layer to expose the planarization layer in the non-display area.

The bank may be in contact with the planarization layer in the plurality of first openings.

A height of the bank overlapping the protection layer may be higher than a height of the bank overlapping the plurality of first openings.

A thickness of the bank overlapping the protection layer may be thicker than a thickness of the bank overlapping the plurality of first openings.

A lower surface of the adhesive layer may be in contact with the bank in the non-display area.

A second opening exposing the planarization layer in the plurality of first openings may be disposed in the bank.

The planarization layer exposed by the plurality of first openings and the second opening may be in contact with the adhesive layer.

Concave portions disposed in an upper surface of the planarization layer may be in contact with the adhesive layer.

The protection layer disposed between the plurality of first openings may be in contact with the adhesive layer.

The bank may be disposed not to overlap the plurality of first openings but to completely overlap the protection layer.

The protection layer may be made of an inorganic material.

The display device may further comprise: a thin film transistor on the first substrate, wherein the planarization layer may be disposed on the thin film transistor, the organic layer of the light emitting diode may include an organic emitting layer, one or more openings may be formed in the protection layer to expose one or more portions of the planarization layer, the bank may contact the at least a portion of the protection layer, and the second substrate may be disposed on the adhesive layer.

The planarization layer may include an organic material and the protection layer may include an inorganic material.

The protection layer may cover at least a portion of the side surface of the planarization layer in the non-display area, and the protection layer may cover the end of the anode of the light emitting diode in the display area.

The bank may be disposed within an opening in the protection layer on a portion of the planarization layer, and a first thickness of the bank on the portion of the planarization layer may be smaller than a second thickness of the bank on the portion of the protection layer.

A first part of the bank and a second part of the bank may be separated from each other, and the adhesive layer may contact a portion of the planarization layer disposed between the first part and the second part of the bank.

The planarization layer within an opening may have a concave surface.

The bank may be disposed on a second portion of the protection layer disposed between a first opening and a second opening in the protection layer. Alternatively, the bank may be not disposed on a second portion of the protection layer disposed between a first opening and a second opening in the protection layer.

According to another aspect of the present disclosure, a display device comprises: a substrate; a thin film transistor on the substrate; an insulating layer on the thin film transistor; a light emitting diode on the insulating layer, the light emitting diode including: a first electrode, an organic emitting layer, and a second electrode; a protection layer on the insulating layer, wherein one or more openings are formed in the protection layer to expose one or more portions of the insulating layer; a bank disposed on and contacting at least a portion of the protection layer; an adhesive layer on the bank; and a second substrate on the adhesive layer.

The bank may be disposed within an opening in the protection layer on a portion of the insulating layer, and a first thickness of the bank on the portion of the insulating layer may be smaller than a second thickness of the bank on the portion of the protection layer.

A first part of the bank and a second part of the bank may be separated from each other, and the adhesive layer may contact a portion of the insulating layer disposed between the first part and the second part of the bank.

The insulating layer within an opening may have a concave surface.

The bank may be disposed on a second portion of the protection layer disposed between a first opening and a second opening in the protection layer. Alternatively, the bank may be not disposed on a second portion of the protection layer disposed between a first opening and a second opening in the protection layer.

The insulating layer may include an organic material and the protection layer includes an inorganic material.

The protection layer may cover at least a portion of a side surface of the insulating layer in a non-display area of the substrate, and the protection layer may cover an end of the first electrode of the light emitting diode in a display area.

## Claims

1. A display device (100, 200, 300, 400), comprising:
a first substrate (110) having a display area (AA) and a non-display area (NA);
a planarization layer (130, 330) disposed in the display area (AA) and the non-display area (NA) on the first substrate (110);
a light emitting diode (OLED) disposed in the display area (AA) on the planarization layer (130, 330) and including an anode (AN), an organic layer, and a cathode (CA);
a protection layer (140, 240) disposed in the display area (AA) and the non-display area (NA) on the planarization layer (130, 330), and disposed to cover an end of the anode (AN) and to surround a side surface of the planarization layer (130, 330);
a bank (150, 250, 350, 450) disposed on at least a portion of the protection layer (140, 240) to cover the end of the anode (AN);
a second substrate (170) disposed to face the first substrate (110); and
an adhesive layer (160, 260, 360, 460) disposed on the bank (150, 250, 350, 450) to adhere the second substrate (170) to the first substrate (110).

2. The display device (100, 200, 300, 400) according to claim 1, wherein a plurality of first openings (OP1) is disposed in the protection layer (140, 240) to expose the planarization layer (130, 330) in the non-display area (NA).

3. The display device (100, 200) according to claim 2, wherein the bank (150, 250) is in contact with the planarization layer (130) in the plurality of first openings (OP1).

4. The display device (100, 200) according to claim 3, wherein a height (h1) of the bank (150, 250) overlapping the protection layer (140, 240) is higher than a height (h2) of the bank (150, 250) overlapping the plurality of first openings (OP1).

5. The display device (100, 200) according to claim 3 or 4, wherein a thickness (d1) of the bank (150, 250) overlapping the protection layer (140, 240) is thicker than a thickness (d2) of the bank (150, 250) overlapping the plurality of first openings (OP1).

6. The display device (100, 200) according to any of claims 3 to 5, wherein a lower surface of the adhesive layer (160, 260) is in contact with the bank (150, 250) in the non-display area (NA).

7. The display device (200) according to any of claims 3 to 6, wherein a second opening (OP2) exposing the planarization layer (130) in the plurality of first openings (OP1) is disposed in the bank (250).

8. The display device (200) according to claim 7, wherein the planarization layer (130) exposed by the plurality of first openings (OP1) and the second opening (OP2) is in contact with the adhesive layer (260).

9. The display device (300, 400) according to any of claims 2 to 8, wherein concave portions (OM) disposed in an upper surface of the planarization layer (330) are in contact with the adhesive layer (360, 460).

10. The display device (300) according to any of claims 2 to 9, wherein the protection layer (140) disposed between the plurality of first openings (OP1) is in contact with the adhesive layer (360), or
wherein the bank (450) is disposed not to overlap the plurality of first openings (OP1) but to completely overlap the protection layer (140).

11. The display device (100, 200, 300, 400) according to any of claims 1 to 10, wherein the protection layer (140, 240) is made of an inorganic material.

12. The display device (100, 200, 300, 400) according to claim 1, further comprising:
a thin film transistor (TR) on the first substrate (110), wherein the planarization layer (130, 330) is disposed on the thin film transistor (TR);
wherein the organic layer of the light emitting diode (OLED) includes an organic emitting layer;
wherein one or more openings (OP1) are formed in the protection layer (140, 240) to expose one or more portions of the planarization layer (130, 330);
wherein the bank (150, 250, 350, 450) contacts the at least a portion of the protection layer (140, 240); and
wherein the second substrate (170) is disposed on the adhesive layer (160, 260, 360, 460),
wherein, preferably, the planarization layer (130, 330) includes an organic material and the protection layer (140, 240) includes an inorganic material,
wherein, further preferably, the protection layer (140, 240) covers at least a portion of the side surface of the planarization layer (130, 330) in the non-display area (NA), and the protection layer (140, 240) covers the end of the anode (AN) of the light emitting diode (OLED) in the display area (AA).

13. The display device (100, 200) of claim 12, wherein the bank (150, 250) is disposed within an opening (OP1) in the protection layer (140, 240) on a portion of the planarization layer (130), and wherein a first thickness (d2) of the bank (150, 250) on the portion of the planarization layer (130) is smaller than a second thickness (d1) of the bank (150, 250) on the portion of the protection layer (140, 240).

14. The display device (200, 400) of claim 12 or 13, wherein a first part of the bank (250, 450) and a second part of the bank (250, 450) are separated from each other, and wherein the adhesive layer (260, 460) contacts a portion of the planarization layer (130, 330) disposed between the first part and the second part of the bank (250, 450).

15. The display device (300, 400) of any of claims 12 to 14, wherein the planarization layer (330) within an opening (OP1) has a concave surface,
wherein, preferably:
the bank (450) is disposed on a second portion of the protection layer (140) disposed between a first opening (OP1) and a second opening (OP1) in the protection layer (140), or
the bank (350) is not disposed on a second portion of the protection layer (140) disposed between a first opening (OP1) and a second opening (OP1) in the protection layer (140).
